# EUROPEAN PATENT APPLICATION

(11) **EP 1 993 107 A1**
(43) Date of publication of application: **19.11.2008**
(21) Application number: 07715247.8
(22) Date of filing: 06.03.2007
(51) Int. Cl.: H01B 13/00, C22F 1/00, H01B 12/10, H01F 6/06

(54) **PRECURSOR OF POWDER-METHOD Nb3Sn SUPERCONDUCTING WIRE ROD, AND POWDER-METHOD Nb3Sn SUPERCONDUCTING WIRE ROD**

(30) Priority: 07.03.2006 JP 2006061299
(71) Applicant: KABUSHIKI KAISHA KOBE SEIKO SHO, Kobe-shi, Hyogo 651-8585 (JP)
(72) Inventor: ZAITSU, Kyoji, c/o Kobe Corporate Research Laboratories, Nishi-ku, Kobe-shi, Hyogo 651-2271 (JP); MIYAZAKI, Takayoshi, c/o Kobe Corporate Research Laboratories, Nishi-ku, Kobe-shi, Hyogo 651-2271 (JP)
(74) Representative: Müller-Boré & Partner Patentanwälte
(86) International application number: PCT/JP2007/054356
(87) International publication number: WO 2007/102517

(57) **Abstract**

There is provided a Nb₃Sn superconducting wire having excellent superconducting properties, the wire being produced by a powder process, and a precursor of the Nb₃Sn superconducting wire produced by a powder process, the precursor being capable of increasing the efficiency of the formation reaction of Nb₃Sn even in a relatively low practical temperature range of about 600°C to about 750°C.

The precursor of the present invention is a precursor of a Nb₃Sn superconducting wire produced by a powder process including filling a sheath containing at least Nb with a material powder containing at least Sn, subjecting the resulting sheath filled with the powder to diameter reduction to form a wire, and subjecting the resulting wire to heat treatment to form a superconducting layer at the interface between the sheath and the powder. The material powder contains a Cu component. The sheath has a structure in which a Nb or Nb-based-alloy portion is combined with a Cu or Cu-based-alloy portion.

## Description

### Technical Field

The present invention relates to Nb₃Sn superconducting wires by a powder process and precursors of the wires. In particular, the present invention relates to a Nb₃Sn superconducting wire produced by a powder process, the wire being useful as a component of superconducting magnets used for generating high magnetic fields, and a precursor of the wire.

### Background Art

Among the fields in which superconducting wires are practically used, with respect to superconducting magnets used in high-resolution nuclear magnetic resonance (NMR) spectrometers, higher magnetic fields generated by magnets result in higher resolution. Accordingly, in recent years, there have been advances in the increase in magnetic field of superconducting magnets.

For example, Nb₃Sn wires have been practically used as superconducting wires for use in superconducting magnets capable of generating high magnetic fields. Nb₃Sn wires are mainly manufactured by the bronze process. In the bronze process, Nb-based cores are embedded in a Cu-Sn-based alloy (bronze) matrix and drawn into filaments (hereinafter referred to as "Nb-based filaments"). The filaments are bundled to make a filament bundle. The filament bundle is embedded in copper for stabilization (stabilizing copper) and subjected to drawing. The resulting bundle is subjected to heat treatment (diffusion heat treatment) at 600°C to 800°C, thereby forming a Nb₃Sn phase at each interface between a corresponding one of the Nb-based filaments and the matrix. However, the bronze process is disadvantageous in that the solid solubility of Sn in bronze has a limit (15.8% by mass or less), thereby resulting in a small amount of Nb₃Sn phase. Furthermore, the crystallinity of Nb₃Sn is degraded, thus resulting in poor properties in high magnetic fields.

In addition to the bronze process, an internal diffusion process is also known as a method for manufacturing a Nb₃Sn superconducting wire. In this internal diffusion process, a Sn core is embedded in the middle of a Cu matrix. A plurality of Nb wires are arranged in the Cu matrix around the Sn core, subjected to diameter reduction, and heat treatment. Thus, Sn is diffused and allowed to react with Nb to form Nb₃Sn (for example, Patent Document 1). This process has no limit of the Sn concentration, unlike the bronze process, which limits the Sn concentration due to the solid solubility limit. Accordingly, the Sn concentration can be set as high as possible to improve the superconducting properties of the resulting wire. However, the internal diffusion process has the following disadvantages: the Sn core is in direct contact with the Cu matrix, thereby easily forming a brittle Cu-Sn compound. Thus, annealing when being working is not applied. This results in a working limit, i.e., high deformation is difficult to perform.

Another known example of a method for producing a Nb₃Sn superconducting wire is a powder process. For example, Patent Document 2 discloses subjecting Sn and at least one metal (alloy element) selected from the group consisting of Ti, Zr, Hf, V, and Ta to a melt-diffusion reaction at a high temperature to form an alloy or intermetallic compound (hereinafter, also referred to as a "Sn compound"), pulverizing the resulting Sn compound to form a Sn compound material powder, filling a sheath composed of Nb or a Nb-based alloy with the powder as a core (powder core described below), subjecting the sheath to diameter reduction, and heat treatment (diffusion heat treatment). Unlike the bronze process, in this process, there is no limitation of the amount of Sn. Furthermore, a Sn portion is not in direct contact with a Cu portion, making it possible to perform annealing when being working and thus high deformation. Moreover, it is possible to form a high-quality Nb₃Sn layer. Thus, a superconducting wire can be obtained with excellent high-magnetic-field properties.

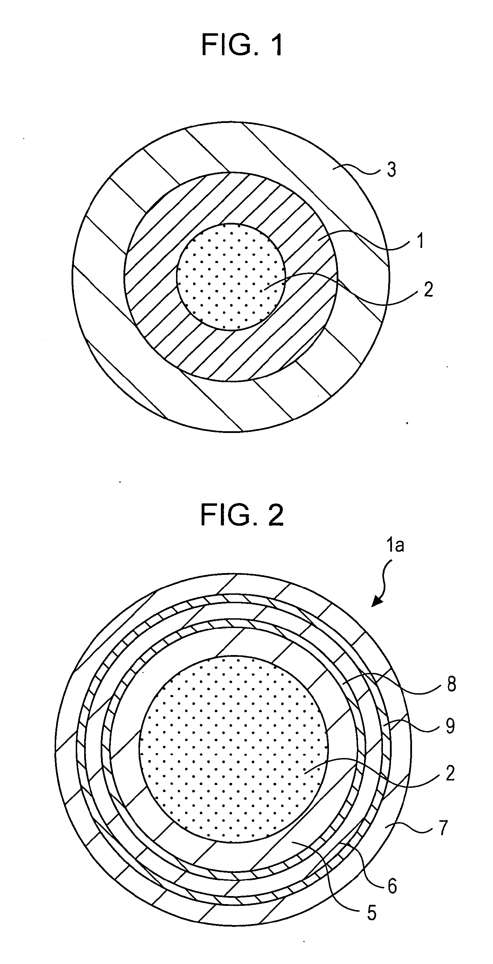

Fig. 1 is a schematic cross-sectional view illustrating a state in producing a Nb₃Sn superconducting wire by the powder process. Fig. 1 shows a sheath (cylinder) 1 composed of Nb or a Nb-based alloy, a powder core portion 2 to be filled with a material powder, and a Cu coating 3 that covers the periphery of the sheath. The Cu coating 3 is arranged as a stabilizing material for the Nb₃Sn superconducting wire and composed of, for example, oxygen-free copper.

In the powder process, the powder core portion 2 is filled with a material powder containing at least Sn and subjected to diameter reduction, e.g., extrusion or wire drawing, to form a primary composite wire (precursor of a superconducting wire). The resulting wire is wound to form a coil. The coil is subjected to heat treatment to form a Nb₃Sn superconducting phase at the interface between the sheath and the material powder.

To form a superconducting phase in such a Nb-Sn binary system, it is necessary to perform heat treatment at a high temperature of at least about 900°C to about 1,000°C. At such a high temperature, a large heat treatment furnace is required. Furthermore, in the case where the wire is used as a high-magnetic-field superconducting magnet, the superconducting wire is closely wound to form a solenoid and then subjected to heat treatment. To prevent electrical short circuits, an insulator made of glass fibers is arranged on the periphery of the wire. However, the heat treatment at a high temperature disadvantageously causes embrittlement of the insulator made of glass fibers.

It is known that the addition of Cu to the material powder allows the reaction to proceed even at a heat treatment temperature of about 600°C to about 750°C. Therefore, in the powder process, it is common to add an appropriate amount of a Cu powder to a material powder and then perform heat treatment for forming an intermetallic compound. Fig. 1 schematically shows a single core. In practice, a multicore superconducting wire in which a plurality of the primary composite wires are arranged in a Cu billet (cylindrical member) is commonly used.
[Patent Document 1] Japanese Unexamined Patent Application Publication No. 49-114389
[Patent Document 2] Japanese Unexamined Patent Application Publication No. 11-250749

### Disclosure of Invention

### Problems to be Solved by the Invention

As described above, it is known that the addition of Cu to the material powder reduces the heat treatment temperature to about 600°C to about 750°C. In the case where the heat treatment is performed at a temperature within the range above, disadvantageously, the diffusion rate of Sn into Nb or a Nb-based alloy (hereinafter, also referred to collectively as a "Nb-based metal") is very low. In the powder process including adding a Cu powder to a material powder, with respect to the reaction for forming Nb₃Sn, the diffusion of Cu into the Nb-based metal and the diffusion of Sn into the Nb-based metal are both required in order that the reaction of Sn proceeds effectively. Thus, even when the powder process having no limit of the solid solubility of Sn is employed, the reaction is limited to diffusion rates of Sn and Cu. The advantage that a large amount of Sn is contained is not sufficiently taken of the process. In many cases, adequate reaction efficiency is not obtained because unreacted Sn is present in the powder core.

The present invention has been accomplished under the foregoing circumstances. It is an object of the present invention to provide a Nb₃Sn superconducting wire having excellent superconducting properties, the wire being produced by a powder process, and a precursor thereof capable of increasing the efficiency of the formation reaction of Nb₃Sn even in a relatively low practical temperature range of about 600°C to about 750°C. Means for Solving the Problems

According to an aspect of the present invention, a precursor achieving the foregoing object of the present invention is a precursor of a Nb₃Sn superconducting wire produced by a powder process including filling a sheath containing at least Nb with a material powder containing at least Sn, subjecting the resulting sheath filled with the powder to diameter reduction to form a wire, and subjecting the resulting wire to heat treatment to form a superconducting layer at the interface between the sheath and the powder, in which the material powder contains a Cu component, and the sheath has a structure in which a Nb or Nb-based-alloy portion is combined with a Cu or Cu-based-alloy portion.

With respect to the precursor of the present invention, preferred requirements are as follows: (A) the mass ratio of the Nb or Nb-based-alloy portion (hereinafter, also referred to, collectively, as a "Nb-based-metal portion") to the Cu or Cu-based-alloy portion (hereinafter, also referred to, collectively, as a "Cu-based-metal portion") in the sheath, i.e., Nb-based-metal portion:Cu-based-metal portion, is 50:1 to 5:1 (mass ratio); (B) the sheath is configured in such a manner that the material powder is not in contact with the Cu-based-metal portion before heat treatment; and (C) the precursor includes a Sn diffusion barrier layer on the outer periphery of the sheath, the Sn-diffusion-barrier layer being composed of Nb or Ta.

The material powder used in the present invention preferably has a Cu component content of 2 to 15 percent by mass with respect to the whole of the material powder. Another preferred embodiment of the material powder is a mixture of an alloy powder composed of Sn and at least one metal selected from the group consisting of Ti, Zr, Hf, V, and Ta, or an intermetallic-compound powder composed of Sn and at least one metal selected from the group consisting of Ti, Zr, Hf, V, and Ta, a Sn powder, and a Cu powder.

In the case where a superconducting wire is produced using the precursor of the present invention, a single-core wire including a Cu coating portion that covers the outer periphery of the sheath is subjected to wiredrawing to form a primary composite wire, and the resulting primary composite wire is subjected to heat treatment to form a single-core superconducting wire. Furthermore, a single-core wire including a Cu coating portion that covers the outer periphery of the sheath is subjected to wiredrawing to form a primary composite wire, a plurality of primary composite wires are inserted into a copper billet to form a multicore composite wire, and the multicore composite wire is subjected to wiredrawing and then heat treatment to form a multicore Nb₃Sn superconducting wire.

### Advantages

In the present invention, the use of the sheath having the structure in which the Nb or Nb-based-alloy portion is combined with the Cu or Cu-based-alloy portion facilitates the formation reaction of a Nb₃Sn phase. Furthermore, the Cu or Cu-based-alloy portion serves as a bypass for the diffusion of Sn, thereby increasing the diffusion rate of Sn. Thus, the amount of Sn remaining in the core is minimized even at a heat treatment temperature of about 600°C to about 750°C, thereby uniformly forming the Nb₃Sn superconducting phase with sufficient reaction efficiency. This results in a Nb₃Sn superconducting wire having a high critical current density.

### Brief Description of Drawings

Fig. 1 is a schematic cross-sectional view of a state in producing a Nb₃Sn superconducting wire by a powder process.
Fig. 2 is a schematic cross-sectional view of a structure of a sheath for use in a precursor of the present invention.
Fig. 3 is a schematic cross-sectional view of another structure of the sheath for use in a precursor of the present invention.
Fig. 4 is a schematic cross-sectional view of still another structure of the sheath for use in a precursor of the present invention.
Fig. 5 is a schematic cross-sectional view of another structure of the sheath for use in a precursor of the present invention.
Fig. 6 is a schematic cross-sectional view of a structure of the sheath when a Sn diffusion barrier layer is arranged.

### Reference Numerals

1, 1a, 1b sheath
2 powder core portion
3 Cu coating
5, 6, 7 Nb-based-metal cylinder
8, 9 Cu-based-metal cylinder
10 Nb-based-metal sheet
11 Cu-based-metal sheet

### Best Modes for Carrying Out the Invention

To achieve the foregoing object, the inventors have conducted intensive studies from various angles and have found that in the case where a Nb₃Sn superconducting wire is produced by a powder process, the use of a sheath constituted by a combination of a Nb-based-metal portion and a Cu-based-metal portion achieves the object. This finding has resulted in the completion of the present invention.

The structure of the present invention will be described below with reference to the drawings. Fig. 2 is a schematic cross-sectional view of a structure of a precursor of the present invention. A sheath 1a for use in the precursor of the present invention includes Nb-based-metal cylinders 5, 6, and 7 and Cu-based-metal cylinders 8 and 9, in which these layers are alternately stacked in such a manner that the innermost layer and the outermost layer are the Nb-based-metal cylinder 5 and the Nb-based-metal cylinder 7, respectively. That is, the sheath used in the present invention is constituted by a Nb-based-metal portion including the Nb-based-metal cylinders 5, 6, and 7 and a Cu-based-metal portion including the Cu-based-metal cylinders 8 and 9. The powder core portion 2 constituted by these stacked members will be filled with a material powder.

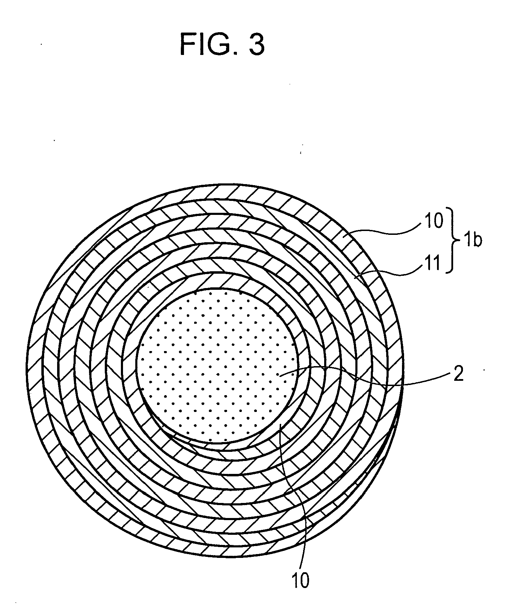

Fig. 3 is a schematic cross-sectional view of another structure of the sheath for use in the precursor of the present invention. The figure illustrates a Nb-based-metal sheet 10 (sheet composed of Nb or a Nb-based alloy) and a Cu-based-metal sheet 11 (sheet composed of Cu or a Cu-based alloy). In this structure, two different sheet members (Nb-based-metal sheet 10 and Cu-based-metal sheet 11) are laminated and wound into a cylindrical sheath 1b. Also in the case where this structure is employed, the sheath 1b has the Nb-based-metal sheet 10 as the innermost layer. The central powder core portion 2 constituted by the winding sheet members will be filled with a material powder in the same way as in the structure shown in Fig. 2.

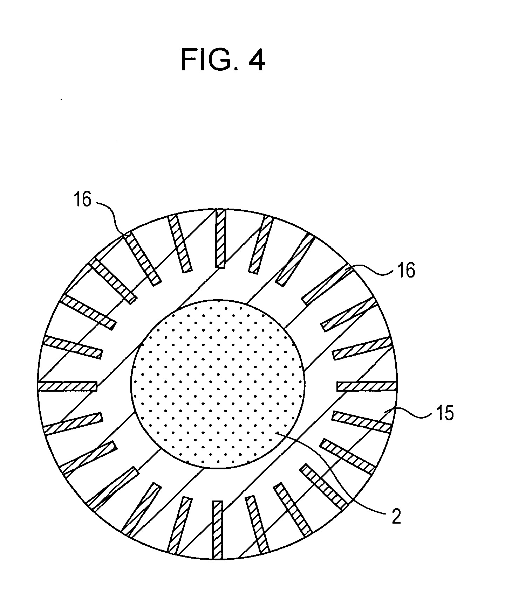

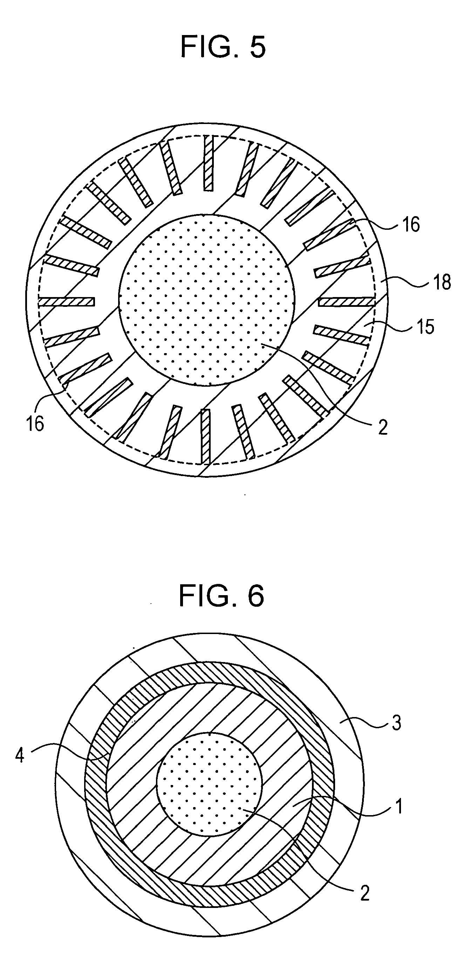

Fig. 4 is a schematic cross-sectional view of still another structure of the sheath for use in the precursor of the present invention. In this structure, a Nb-based-metal sheath 15 has longitudinally extending circumferentially spaced grooves. Cu or Cu-based-alloy plates 16 are fitted into the grooves, thereby forming the sheath 15 having a Cu-based-metal portion (Cu or Cu-based-alloy plates). Also in this structure, the Cu or Cu-based-alloy plates 16 are arranged within the thickness of the sheath 15 so as not to be exposed at the inner surface thereof, and the inner surface of the sheath 15 is composed of the Nb-based metal. The sheath 15 has a perimeter at which the Cu plates 16 are partially exposed. Alternatively, for example, as shown in Fig. 5, the perimeter may be covered with a Nb-based-metal cylindrical member or sheet member 18 in such a manner that the Cu or Cu-based-alloy plates 16 are embedded in the sheath 15.

Even if any of the structures shown in Figs. 2 to 5 is employed, the sheath used in the present invention is constituted by a combination of the Nb-based-metal portion and the Cu-based-metal portion. Thus, the Cu-based-metal portion facilitates the formation reaction of Nb₃Sn and serves as a bypass for the diffusion of Sn, thereby increasing the amount of Sn participating in the formation of a Nb₃Sn phase to contribute to improvement in superconducting properties. In other words, in the case of heat treatment at a relatively low temperature (600°C to 750°C, preferably 600°C to 700°C), the diffusion rate of Sn in Cu is higher than that in the Nb-based metal. Thus, the arrangement of the foregoing Cu-based-metal portion in the sheath significantly increases the diffusion rate of Sn, thereby providing the foregoing effect.

To provide the effect, preferably, the ratio of the Nb-based-metal portion to the Cu-based-metal portion in the sheath is appropriately adjusted. From such a viewpoint, the Cu-based-metal portion is preferably arranged in such a manner that the ratio of the Nb-based-metal portion to the Cu-based-metal portion is 50:1 or more (ratio by mass). When the Cu-based-metal-portion content is very high, Cu acts as an impurity in Nb₃Sn formed and is liable to cause a reduction in superconducting properties. Furthermore, the effective area of Nb₃Sn is reduced; hence, the ratio should be 5:1 or less. Preferably, the Nb-based alloy constituting the sheath of the present invention has a Nb content of 90% by mass or more and contains alloy elements, such as Ta and Ti, in an amount of 10% by mass or less. The Cu-based alloy combined with the Nb or Nb-based alloy in the sheath has a Cu content of 90% by mass. It is possible to use the Cu-based alloy containing alloy elements, such as Pb, Fe, Zn, Al, Mn, and P, in an amount of 10% by mass or less as long as the processability of the superconducting wire is not impaired.

On the other hand, a material powder used in the powder process contains at least Sn. In a structure in which Sn is in direct contact with Cu, a brittle Cu-Sn compound may be formed by heat treatment to degrade wire-drawing processability. Thus, as shown in Figs. 2 to 5, the Cu-based-metal portion in the sheath is preferably arranged so as not to be in direct contact with the powder core portion. However, when the distance between the inner periphery of the sheath and the Cu-based-metal portion is excessively large, the function as a bypass for the diffusion of the Sn component is not provided. Thus, the Cu-based-metal portion is preferably located in a region from the inner periphery of the sheath to a position t/10 distant from the inner periphery, where t denotes the thickness of the sheath.

After the outer periphery of the single-core wire shown in each of Figs. 2 to 5 is covered with a Cu coating layer (see reference numeral 3 shown in Fig. 1), the resulting wire is subjected to diameter reduction to form a primary composite wire, followed by heat treatment to produce a superconducting wire. A plurality of the primary composite wires are arranged in a Cu billet to form a multicore composite wire. The multicore composite wire is subjected to wire drawing and heat treatment, thereby producing a multicore superconducting wire.

In any process, a Cu coating layer is formed on the outer periphery of the sheath. In the case of the sheath including the Cu portion described above, the extremely rapid diffusion of Sn may result in the penetration of Sn into the Cu coating layer to contaminate the Cu coating layer. To eliminate such a disadvantage, as shown in Fig. 6, a Sn-diffusion-barrier layer 4 composed of, for example, Ta or a Ta-based alloy is arranged on the outer periphery of the sheath (inner periphery of the Cu coating layer), which is a preferred embodiment. Alternatively, the sheath has the outermost layer composed of Nb or the Nb-based alloy (for example, see Figs. 2, 3, and 5), the layer having a relatively large thickness so as to serve as the Sn-diffusion-barrier layer. In Fig. 6, for convenience of illustration, the detailed structure of the sheath is omitted.

The material powder used in the present invention needs to contain at least Sn serving as a component constituting the Nb₃Sn phase. To allow the formation reaction of Nb₃Sn to efficiently proceed even when diffusion heat treatment is performed at a relatively low temperature (600°C to 750°C), the material powder needs to contain a Cu component. To provide the effect, the material powder preferably has a Cu-component content of 2% by mass or more. An excessively large Cu-component content may result in an increase in impurity content to reduce the superconducting properties in the same way as the Cu-based-metal portion in the sheath. Thus, the material powder should have a Cu-component content of 15% by mass or less.

With respect to the material powder, it is known that the incorporation of Sn and at least one metal (alloy element) selected from the group consisting of Ti, Zr, Hf, V, and Ta can result in a small amount of a solid solution in a reaction layer during the formation of Nb₃Sn to improve superconducting properties. In the case where such a process is employed, powders of Sn, at least one metal selected from the group consisting of Ti, Zr, Hf, V, and Ta, and Cu are appropriately weighed and mixed. The resulting mixture is subjected to heat treatment, followed by pulverization. However, when the powder process is performed according to the procedure, a very hard Cu-Sn compound is simultaneously formed during the heat treatment. The presence of the Cu-Sn compound causes the abnormal deformation in the course of diameter reduction and, at worst, induces a break in the wire.

The inventors, therefore, have conducted intensive studies on a material powder eliminating the disadvantage and capable of forming a Nb₃Sn superconducting wire with satisfactory superconducting properties and have conceived that during a melt-diffusion reaction, the total amount of Sn as a material is not allowed to react and that the minimum amount of Sn necessary to alloy the alloy element, such as Ti, Zr, Hf, V, or Ta, may be allowed to react. Furthermore, the inventors have conceived that with respect to Cu, Cu is not added during the melt-diffusion reaction and that Cu is added to the material powder after the reaction in order to effectively provide the effect of the addition of Cu on a reduction in heat treatment temperature. Then the inventors have found that a mixture of an alloy powder composed of Sn and at least one metal selected from the group consisting of Ti, Zr, Hf, V, and Ta, or an intermetallic compound powder composed of Sn and at least one metal selected from the group consisting of Ti, Zr, Hf, V, and Ta (hereinafter, referred to as a "Sn compound powder"), a Sn powder, and a Cu powder eliminates the foregoing disadvantage and provides satisfactory superconducting properties.

As the material powder used in the present invention, the above-described material powder may be used. In the material powder, the Cu powder is added after the Sn compound powder is prepared. Thus, the material powder provides a wire without the formation of a hard Sn-Cu compound during the formation reaction of the Sn compound (melt-diffusion reaction) and minimizes abnormal deformation and the occurrence of a break in the wire during the processing of the wire.

The Sn compound powder described above is prepared by subjecting an alloy element, such as Ti, Zr, Hf, V, or Ta, and Sn to the melt-diffusion reaction. The mixing ratio of the alloy element to Sn is not particularly limited. The mixing ratio of the alloy element to Sn, i.e., alloy element:Sn, is preferably about 4:1 to about 1:2 (atomic ratio) from the viewpoint of achieving good superconducting properties.

The material powder is prepared by forming the Sn compound, pulverizing the compound to form the Sn compound powder, adding the Sn powder and the Cu powder to the resulting Sn compound powder, and mixing the resulting mixture. With respect to the mixing ratio in the material powder, the Sn powder is in the range of 15 to 90 parts by mass, and the Cu powder is in the range of 1 to 20 parts by mass relative to 100 parts by mass of the Sn compound powder. However, the Cu content is preferably in the range of 2 to 15 percent by mass and more preferably 2 to 5 percent by mass on the basis of the foregoing purport.

In the case of using the material powder, when the mixing ratio of the Sn powder is less than 15 parts by mass, it is difficult to provide the effect of the addition of Sn on improvement in superconducting property. When the mixing ratio of the Sn powder exceeds 90 parts by mass, the amount of the alloy element in the material powder is relatively reduced, causing elution of Sn due to heat generated during extrusion. When the mixing ratio of the Cu powder is less than 1 part by mass, the effect of the addition of Cu on a reduction in heat treatment temperature (temperature in diffusion heat treatment) is not provided. When the mixing ratio of the Cu powder exceeds 20 parts by mass, a large amount of a hard Cu-Sn compound is formed in the core during annealing, thereby degrading the processability of the wire and causing frequent breaks in the wire.

In the case of filling the sheath with the material powder, uniaxial pressing is usually employed. Instead of such a process, compacting treatment with isotropic pressure, e.g., cold isostatic pressing (CIP), is performed to increase the filling rate of the material powder and is preferred in order to perform uniform processing. For example, in the structure shown in Fig. 3, if the material powder in the powder core portion 2 has been subjected to compacting treatment, the sheath can be readily formed by winding the sheet member around the periphery thereof. Also in the case where the sheath is constituted by the cylindrical members as shown in Fig. 2, the material powder having been subjected to compacting treatment may be naturally used. When CIP is performed, a rubber mold is filled with a material powder, and then the mold is subjected to CIP. The formed article obtained by CIP can be subjected to machining. This results in an increase in the assembly accuracy of the composite wire.

While the present invention will be described in more specific by examples, the following examples are not limited to the present invention. Design changes in accordance with the purport described above and below are included within the technical range of the present invention. For example, in these examples described below, single-core superconducting wires are exemplified. Alternatively, the present invention is also applicable to a superconducting wire including a multicore composite wire in which a plurality of single cores are arranged in a Cu matrix.

### EXAMPLES

### [EXAMPLE 1]

Ta and Sn powders were weighed with an electronic balance in an Ar gas atmosphere in such a manner that Ta:Sn = 6:5 (atomic ratio). The powders were mixed in a V-blender for 30 minutes. The resulting powder mixture was subjected to heat treatment at 950°C for 10 hours in vacuum to form a Ta-Sn compound.

The resulting Ta-Sn compound was roughly crushed and then pulverized for 1 hour in an Ar atmosphere with an automatic mortar to form the Ta-Sn compound powder having a particle diameter of 75 µm or less. To the Ta-Sn compound powder, 25% by mass of a Sn powder and 5% by mass of a Cu powder were added. The mixture was mixed to form a material powder (Sn-based powder).

On the other hand, members (A) to (E) described below were stacked in sequence to form a composite sheath (see Fig. 2). The composite sheath was filled with the material powder. The composite sheath was further combined with an oxygen-free copper pipe having an outer diameter of 65 mm and an inner diameter of 55 mm arranged on the outer periphery of the sheath, thereby forming an extrusion billet.
(A) Pipe, composed of a Nb alloy containing 7.5% by mass Ta, having an outer diameter of 35 mm and an inner diameter of 30 mm
(B) Cu pipe having an outer diameter of 37 mm and an inner diameter of 35 mm
(C) Pipe, composed of a Nb alloy containing 7.5% by mass Ta, having an outer diameter of 42 mm and an inner diameter of 37 mm
(D) Cu pipe having an outer diameter of 44 mm and an inner diameter of 42 mm
(E) Pipe, composed of a Nb alloy containing 7.5% by mass Ta, having an outer diameter of 55 mm and an inner diameter of 44 mm

The extrusion billet having the structure described above was extruded with a hydrostatic extruder and then formed into a wire having a diameter of 1.0 mm by wiredrawing with dies. In this billet, the mass ratio of Nb-Ta to Cu, i.e., Nb-Ta:Cu, was 5.7:1.

The wire was subjected to heat treatment at 700°C for 100 hours in vacuum in order to form Nb₃Sn. After the heat treatment, the critical current (Ic) of the resulting wire was measured while an external magnetic field from a superconducting magnet was applied to the wire. The critical current density of a non-copper area (nonCu-Jc) was evaluated by dividing the Ic by the non-copper area of the cross section of the wire. The critical current density (nonCu-Jc) was determined to be 470 A/mm² at 4.2 K in a magnetic field of 18 T. The reaction rate of the sheath (rate obtained by dividing the cross-sectional area of the Nb₃Sn layer by the total cross-sectional area of the sheath) after the reaction was measured and found to be 67%, which was a high reaction rate.

### [EXAMPLE 2]

Ta and Sn powders were weighed with an electronic balance in an Ar gas atmosphere in such a manner that Ta:Sn = 6:5 (atomic ratio). The powders were mixed in a V-blender for 30 minutes. The resulting powder mixture was subjected to heat treatment at 950°C for 10 hours in vacuum to form a Ta-Sn compound.

The resulting Ta-Sn compound was roughly crushed and then pulverized for 1 hour in an Ar atmosphere with an automatic mortar to form the Ta-Sn compound powder having a particle diameter of 75 µm or less. To the Ta-Sn compound powder, 25% by mass of a Sn powder and 5% by mass of a Cu powder were added. The mixture was mixed to form a material powder (Sn-based powder).

The resulting material powder was placed in a rubber mold and subjected to CIP at 200 MPa for 15 minutes to form a columnar formed article having an outer diameter of 32 mm and a length of 181 mm.

The resulting formed article was mechanically processed into a columnar formed article having an outer diameter of 30 mm and a length of 180 mm. A sheet (Nb-Ta sheet), composed of Nb containing 7.5% by mass Ta, having a thickness of 0.1 mm was wound around the periphery of the formed article in such a manner that the number of turns was 30. A Cu sheet having a thickness of 0.03 mm was inserted. The Nb-Ta sheet was wound together with the Cu sheet in such a manner that the number of turns of the two-sheet winding was 10. Then only the Nb-Ta sheet was wound in such a manner that the number of turns was 80, thereby producing a composite member. In this case, Nb-Ta:Cu (mass ratio) was 48:1.

The composite member was combined with an oxygen-free copper pipe having an outer diameter of 65 mm and an inner diameter of 55 mm, thereby forming an extrusion billet. The extrusion billet having the structure described above was extruded with a hydrostatic extruder and then formed into a wire having a diameter of 1.0 mm by wiredrawing with dies.

The wire was subjected to heat treatment at 700°C for 100 hours in vacuum in order to form Nb₃Sn. After the heat treatment, the critical current (Ic) of the resulting wire was measured while an external magnetic field from a superconducting magnet was applied to the wire. The critical current density of a non-copper area (nonCu-Jc) was evaluated by dividing the Ic by the non-copper area of the cross section of the wire. The critical current density (nonCu-Jc) was determined to be 490 A/mm² at 4.2 K in a magnetic field of 18 T. The reaction rate of the sheath (rate obtained by dividing the cross-sectional area of the Nb₃Sn layer by the total cross-sectional area of the sheath) after the reaction was measured and found to be 70%, which was a high reaction rate.

### [COMPARATIVE EXAMPLE 1]

Ta and Sn powders were weighed with an electronic balance in an Ar gas atmosphere in such a manner that Ta:Sn = 6:5 (atomic ratio). The powders were mixed in a V-blender for 30 minutes. The resulting powder mixture was subjected to heat treatment at 950°C for 10 hours in vacuum to form a Ta-Sn compound.

The resulting Ta-Sn compound was roughly crushed and then pulverized for 1 hour in an Ar atmosphere with an automatic mortar to form the Ta-Sn compound powder having a particle diameter of 75 µm or less. To the Ta-Sn compound powder, 25% by mass of a Sn powder and 5% by mass of a Cu powder were added. The mixture was mixed to form a material powder (Sn-based powder).

The resulting material powder was filled into a sheath, composed of Nb containing 7.5% by mass Ta, having an outer diameter of 55 mm and an inner diameter of 30 mm. The sheath was combined with an oxygen-free copper pipe having an outer diameter of 65 mm and an inner diameter of 55 mm arranged on the outer periphery of the sheath, thereby forming an extrusion billet. The extrusion billet having the structure described above was extruded with a hydrostatic extruder and then formed into a wire having a diameter of 1.0 mm by wiredrawing with dies.

The wire was subjected to heat treatment at 700°C for 100 hours in vacuum in order to form Nb₃Sn. After the heat treatment, the critical current (Ic) of the resulting wire was measured while an external magnetic field from a superconducting magnet was applied to the wire. The critical current density of a non-copper area (nonCu-Jc) was evaluated by dividing the Ic by the non-copper area of the cross section of the wire. The critical current density (nonCu-Jc) was determined to be 310 A/mm² at 4.2 K in a magnetic field of 18 T. The reaction rate of the sheath (rate obtained by dividing the cross-sectional area of the Nb₃Sn layer by the total cross-sectional area of the sheath) after the reaction was measured and found to be 38%, which was a low reaction rate.

## Claims

1. A precursor of a Nb₃Sn superconducting wire produced by a powder process, the precursor comprising a sheath containing at least Nb, the sheath being filled with a material powder containing at least Sn,
wherein the material powder contains a Cu component, and the sheath has a structure in which a Nb or Nb-based-alloy portion is combined with a Cu or Cu-based-alloy portion.

2. The precursor of a Nb₃Sn superconducting wire produced by a powder process according to claim 1, wherein the mass ratio of the Nb or Nb-based-alloy portion to the Cu or Cu-based-alloy portion in the sheath, i.e., (Nb or Nb-based-alloy portion):(Cu or Cu-based-alloy portion), is 50:1 to 5:1 (mass ratio).

3. The precursor of a Nb₃Sn superconducting wire produced by a powder process according to claim 1 or 2, wherein the sheath is configured in such a manner that the material powder is not in contact with the Cu or Cu-based-alloy portion before heat treatment.

4. The precursor of a Nb₃Sn superconducting wire produced by a powder process according to any one of claims 1 to 3, further comprising a Sn diffusion barrier layer on the outer periphery of the sheath, the Sn-diffusion-barrier layer being composed of Nb, a Nb-based alloy, Ta, or a Ta-based alloy.

5. The precursor of a Nb₃Sn superconducting wire produced by a powder process according to any one of claims 1 to 4, wherein the material powder has a Cu component content of 2 to 15 percent by mass with respect to the whole of the material powder.

6. The precursor of a Nb₃Sn superconducting wire produced by a powder process according to any one of claims 1 to 5, wherein the material powder is a mixture of
an alloy powder composed of Sn and at least one metal selected from the group consisting of Ti, Zr, Hf, V, and Ta, or an intermetallic-compound powder composed of Sn and at least one metal selected from the group consisting of Ti, Zr, Hf, V, and Ta,
a Sn powder, and
a Cu powder.

7. A Nb₃Sn superconducting wire produced by a powder process including preparing the precursor of a Nb₃Sn superconducting wire according to any one of claims 1 to 6,
subjecting a single-core wire including a Cu coating portion that covers the outer periphery of the sheath to diameter reduction to form a primary composite wire, and subjecting the resulting primary composite wire to heat treatment.

8. A Nb₃Sn superconducting wire produced by a powder process including preparing the precursor of a Nb₃Sn superconducting wire according to any one of claims 1 to 6,
subjecting a single-core wire including a Cu coating portion that covers the outer periphery of the sheath to diameter reduction to form a primary composite wire, inserting a plurality of primary composite wires into a Cu billet to form a multicore composite wire, and subjecting the multicore composite wire to diameter reduction and heat treatment.
